# EUROPEAN PATENT APPLICATION

(11) **EP 4 737 921 A1**
(43) Date of publication of application: **06.05.2026**
(21) Application number: 24907877.5
(22) Date of filing: 29.11.2024
(51) Int. Cl.: G01R 31/382, G01R 31/396, G01R 19/30, G01R 19/165, H01M 4/505, H01M 10/48, H01M 4/02, H01M 10/42

(54) **APPARATUS AND METHOD FOR MANAGING BATTERY**

(30) Priority: 22.12.2023 KR 20230190471
(71) Applicant: LG Energy Solution, Ltd., Seoul 07335 (KR)
(72) Inventor: CHOI, Hyun-Jun, Daejeon 34122 (KR); KIM, Dae-Soo, Daejeon 34122 (KR); KIM, Young-Deok, Daejeon 34122 (KR)
(74) Representative: Goddar, Heinz J.
(86) International application number: PCT/KR2024/019386
(87) International publication number: WO 2025/135592

(57) **Abstract**

A battery management apparatus according to one embodiment of the present disclosure includes a storage unit configured to store battery information including a voltage and current, and a control unit configured to calculate a capacity ratio of a battery based on the battery information, to compare the calculated capacity ratio for each of a plurality of voltage ranges with a preset reference capacity ratio, and to determine a state of the battery based on a comparison result.

## Description

### TECHNICAL FIELD

This application is based on and claims priority from Korean Patent Application No. 10-2023-0190471, filed on December 22, 2023, with the Korean Intellectual Property Office, the disclosure of which is incorporated herein in its entirety by reference.

The present disclosure relates to a battery management apparatus and method, and more particularly, to a battery management apparatus and method for determining a state of a battery.

### BACKGROUND ART

Recently, as the demand for portable electronic products such as laptops, video cameras, and mobile phones has increased rapidly, and the development of electric vehicles, energy storage batteries, robots, and satellites is in full swing, research on high-performance batteries capable of repeated charging and discharging is being actively conducted.

Currently commercialized batteries include nickel-cadmium batteries, nickel-hydride batteries, nickel-zinc batteries, and lithium batteries. Among these batteries, lithium batteries are gaining attention due to their advantages over the nickel-based batteries, such as minimal memory effects, which allows for more flexible charging and discharging, a very low self-discharge rate, and a high energy density.

Among the electrochemical devices, interest in the development of rechargeable secondary batteries, is also emerging. In particular, the lithium secondary batteries developed in the early 1990s draw attention in that these batteries stand out for their high operating voltage and significantly superior energy density.

Lithium secondary batteries that have been developed up to now mainly use lithium nickel-based oxides as a positive electrode active material, and carbon-based and/or silicon-based materials as a negative electrode active material. However, these conventional lithium secondary batteries do not sufficiently satisfy the energy density required for batteries used in, for example, electric vehicles. Therefore, in an effort to achieve a high capacity of the lithium secondary batteries, a method of applying lithium-excess manganese-based oxides as a positive electrode active material is being considered.

Lithium-excess manganese-based oxides have a crystal structure where a layered phase (LiMO₂) and a rock-salt phase (Li₂MnO₃) are mixed. A higher capacity may be activated through the activation of the rock-salt phase during charging or discharging, which leads to the manifestation of an additional capacity due to oxygen redox reactions. Specifically, since oxygen redox reactions cause manganese redox reactions, thereby further increasing the capacity of the battery. However, there is a problem in that during manganese redox reactions, the crystal structure of the positive electrode active material changes, resulting in deteriorated lifespan characteristics.

### DISCLOSURE

### Technical Problem

The present disclosure is designed to solve the problems of the related art, and therefore the present disclosure is directed to providing a battery management apparatus and method for diagnosing the state of a battery based on the capacity ratio manifested by a positive electrode of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to an aspect of the present disclosure includes a storage unit configured to store battery information including a voltage and current, and a control unit configured to calculate a capacity ratio of a battery based on the battery information, compare the calculated capacity ratio for each of a plurality of voltage ranges with a preset reference capacity ratio, and determine a state of the battery based on a comparison result.

The control unit may be configured to calculate a capacity ratio difference between the capacity ratio for a target voltage range among the plurality of voltage ranges and the reference capacity ratio, and, based on the calculated capacity ratio difference, calculate a manifested capacity ratio due to a positive electrode of the battery.

The control unit may be configured to determine, among the plurality of voltage ranges, a voltage range where the capacity ratio is greater than or equal to the reference capacity ratio, as the target voltage range.

The control unit may be configured to determine, among the plurality of voltage ranges, a voltage range starting from a lowest voltage range where the capacity ratio is greater than or equal to the reference capacity ratio, as the target voltage range.

The control unit may be configured to compare the manifested capacity ratio with a preset threshold, and change a usage condition set for the battery based on a comparison result.

The control unit may be configured to calculate a total capacity for an entire voltage range of the battery, and calculate a ratio of the calculated total capacity that corresponds to a capacity for each voltage range, so as to calculate the capacity ratio for that voltage range.

The battery may be configured to contain a lithium-excess manganese-based oxide having a crystal structure where a layered LiMO₂ phase (where M is Ni, Co, or Mn) and a rock-salt structured Li₂MnO₃ phase are mixed.

A battery pack, according to another aspect of the present disclosure, includes the battery management apparatus according to the one aspect of the present disclosure.

A vehicle, according to a further aspect of the present disclosure, includes the battery management apparatus according to the one aspect of the present disclosure.

A battery management method, according to yet another aspect of the present disclosure, includes calculating a capacity ratio of a battery based on battery information including a voltage and current of the battery, comparing the calculated capacity ratio for each of a plurality of voltage ranges with a preset reference capacity ratio, and determining a state of the battery based on a comparison result from the comparing.

### Advantageous Effects

According to an aspect of the present disclosure, the battery management apparatus determines whether an additional capacity of the battery has manifested and evaluates the amount of the additional capacity, therefore, has an advantage of being able to specifically determine the state of a battery more precisely.

The effects of the present disclosure are not limited to those mentioned above, and other effects that have not mentioned will be clearly understood by those skilled in the art from the description of the claims.

### DESCRIPTION OF DRAWINGS

The following drawings attached hereto exemplify the embodiments of the present disclosure and serve to further understand the technical idea of the present disclosure together with the detailed description of the disclosure to be described later. Therefore, the present disclosure should not be construed as being limited to the matters illustrated in the drawings.
FIG. 1 is a diagram schematically illustrating a battery management apparatus according to one embodiment of the present disclosure.
FIG. 2 is a diagram schematically illustrating battery profile according to one embodiment of the present disclosure.
FIG. 3 is a diagram illustrating the battery profile of FIG. 2, which is divided into a plurality of voltage ranges.
FIG. 4 is a diagram schematically illustrating the capacity ratio for each voltage range and the reference capacity ratio according to one embodiment of the present disclosure.
FIG. 5 is a diagram specifically illustrating the capacity ratio for each voltage range and the reference capacity ratio according to one embodiment of the present disclosure.
FIG. 6 is a diagram schematically illustrating the capacity ratio difference between the capacity ratio for each voltage range and the reference capacity ratio according to one embodiment of the present disclosure.
FIG. 7 is a diagram schematically illustrating the capacity retention of the battery according to one embodiment of the present disclosure.
FIG. 8 is a diagram schematically illustrating an example configuration of a battery pack according to another embodiment of the present disclosure.
FIG. 9 is a diagram schematically illustrating an example configuration of a vehicle according to another embodiment of the present disclosure.
FIG. 10 is a diagram schematically illustrating a battery management method according to another embodiment of the present disclosure.

### BEST MODE

The terms or words used in this specification and the claims should not be interpreted as being limited to their usual or dictionary meanings, but should be interpreted as having meanings and concepts that are consistent with the technical idea of the present disclosure, based on the principles that the inventors may appropriately define the concepts of the terms to describe their disclosure in the best way possible.

The embodiments described in this specification and the configurations illustrated in the drawings are merely the most preferred embodiment of the present disclosure and do not represent all of the technical ideas of the present disclosure, and it should be understood that various equivalents and modifications that may replace them at the time of filing may exist.

When describing the present disclosure, detailed descriptions of related known configurations or functions will be omitted when they deemed to obscure the gist of the present disclosure.

Terms such as "first" and "second" used to include ordinal numbers are intended to distinguish any one of various components from the others and are not used to limit the components by these terms.

When a certain part is said to "include" a certain component throughout the specification, this means that other components may also be included unless specifically stated otherwise, rather than excluding other components.

Throughout the specification, when a certain part is said to be "connected" to another part, this includes not only cases where they are "directly connected" but also cases where they are "indirectly connected" with other elements therebetween.

Hereinafter, preferred embodiments of the present disclosure will be described in detail with reference to the accompanying drawings.

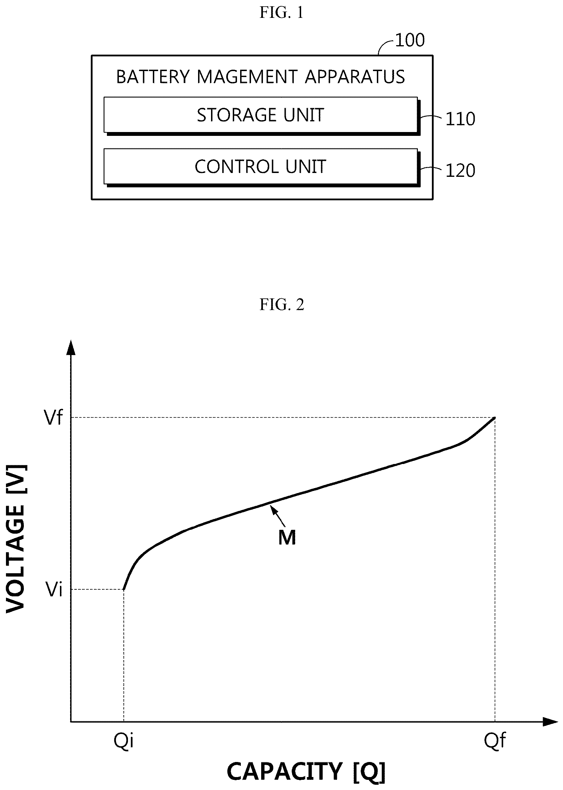

FIG. 1 is a diagram schematically illustrating a battery management apparatus 100 according to one embodiment of the present disclosure.

Referring to FIG. 1, the battery management apparatus 100 may include a storage unit 110 and a control unit 120.

The storage unit 110 may be configured to store battery information including the voltage and current.

Here, the battery is equipped with a negative terminal and a positive terminal, and refers to a single independent cell that is physically separable. As an example, the battery may be a cylindrical, prismatic, or pouch type. Further, the battery may refer to a battery bank, battery module, or battery pack in which a plurality of cells is connected in series and/or in parallel. Hereinafter, for the convenience of description, the battery will be described as referring to a single independent cell.

The storage unit 110 may store data or programs required for the operation and function of each component of the battery management apparatus 100, data generated during the execution of the operation and function, and others. The storage unit 110 is not particularly limited in type as long as it is a known information storage medium capable of recording, erasing, updating, and reading data. Examples of such an information storage medium may include a RAM, flash memory, ROM, EEPROM, register, and others. Additionally, the storage unit 110 may store program codes that define processes executable by the control unit 120.

Preferably, battery information related to the voltage and current measured during the charging or discharging of the battery, may be stored in the storage unit 110. For example, it is assumed that the charging of the battery starts at 0% State of Charge (SOC) and ends at 100% SOC. The storage unit 110 may store battery information including the voltage and current corresponding to SOC levels from 0% to 100%.

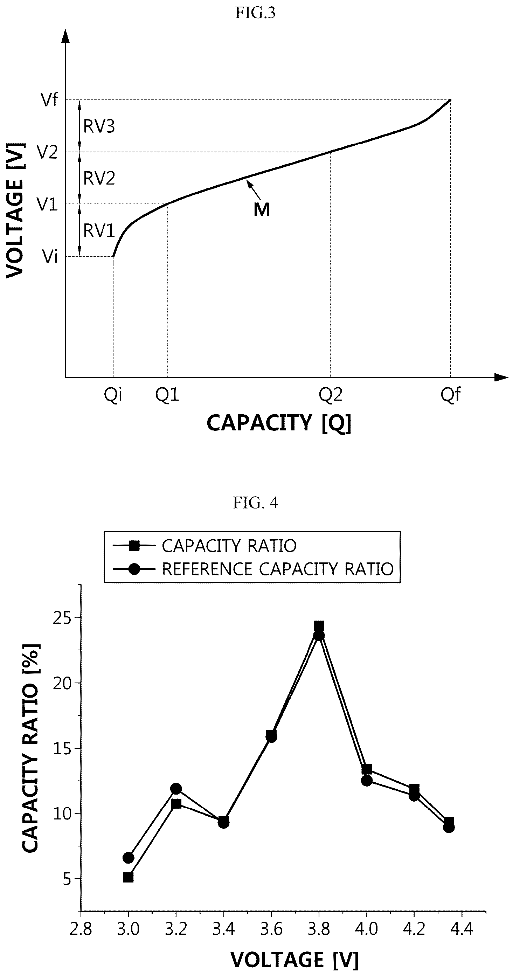

FIG. 2 is a diagram schematically illustrating a voltage profile M for the capacity of the battery 10, according to one embodiment of the present disclosure. Specifically, the battery profile M may be represented as a two-dimensional graph where the X-axis indicates the capacity Q and the Y-axis indicates the voltage V. In the embodiment of FIG. 3, the capacity range of the battery is from Qi to Qf, and the voltage range is from Vi to Vf.

The storage unit 110 may be connected to the control unit 120 to allow wired and/or wireless communications. For example, the storage unit 110 may send battery information to the control unit 120, and the control unit 120 may receive the battery information from the storage unit 110. In another example, the control unit 120 may access the storage unit 110 to retrieve battery information stored in the storage unit 110.

The control unit 120 may be configured to calculate the capacity ratio for each voltage range of the battery based on battery information.

Specifically, the capacity ratio refers to the ratio of the total capacity of the battery that corresponds to the capacity within that voltage range.

First, the control unit 120 may be configured to calculate the total capacity of the battery for the entire voltage range. Here, the entire voltage range refers to the voltage range over which charging or discharging of the battery occurs. Preferably, the entire voltage range refers to the voltage range set for the full charging or discharging of the battery.

For example, it is assumed that the battery is fully charged if the battery is charged from 2.8 V to 4.35 V. In this case, the entire voltage range of the battery is from 2.8 V to 4.35 V.

In another example, it is assumed that the battery is fully discharged if the battery is discharged from 4.35 V to 2.8 V. In this case, the entire voltage range of the battery is from 2.8 V to 4.35 V.

The control unit 120 may be configured to divide the entire voltage range of the battery into a plurality of voltage ranges.

Specifically, the control unit 120 may divide the entire voltage range of the battery into preset voltage increments. For example, the control unit 120 may divide the entire voltage range of the battery into voltage increments of 0.2 V. Assuming that the entire voltage range of the battery is from 2.8 V to 4.35 V, the entire voltage range of the battery may be divided into a first voltage range RV1 (2.8 V to 3.0 V), a second voltage range RV2 (3.0 V to 3.2 V), a third voltage range RV3 (3.2 V to 3.4 V), a fourth voltage range RV4 (3.4 V to 3.6 V), a fifth voltage range RV5 (3.6 V to 3.8 V), a sixth voltage range RV6 (3.8 V to 4.0 V), a seventh voltage range RV7 (4.0 V to 4.2 V), and an eighth voltage range RV8 (4.2 V to 4.35 V).

While the embodiment in which the entire voltage range is divided into voltage increments of 0.2 V has been described above, the voltage increment may be appropriately changed according to the size of the entire voltage range of the battery and the system performance of the battery management apparatus 100.

FIG. 3 is a diagram illustrating the battery profile M of FIG. 2, which is divided into a plurality of voltage ranges.

In the embodiment of FIG. 3, the control unit 120 may divide the entire voltage range (from Vi to Vf) of the battery into the first voltage range RV1, the second voltage range RV2, and the third voltage range RV3. Here, the sizes of the first to third voltage ranges RV1 to RV3 are identical.

The control unit 120 may be configured to calculate the capacity for each voltage range.

Specifically, the control unit 120 may calculate the capacity for each voltage range by calculating the difference between the capacity corresponding to the start voltage (lower limit) and the capacity corresponding to the end voltage (upper limit) of that voltage range.

For example, in the embodiment of FIG. 3, the control unit 120 may calculate the capacity for the first voltage range RV1 as "Q1-Qi", the capacity for the second voltage range RV2 as "Q2-Q1", and the capacity for the third voltage range RV3 as "Qf-Q2".

Finally, the control unit 120 may be configured to calculate the ratio of the calculated total capacity that corresponds to the capacity within each voltage range, thereby calculating the capacity ratio for each voltage range."

Specifically, the control unit 120 may calculate the ratio of the total capacity that corresponds to the capacity within each voltage range. For example, in the embodiment of FIG. 4, the capacity ratio for the first voltage range RV1 may be calculated according to the formula "(Q1-Qi)÷(Qf-Qi)". The capacity ratio for the second voltage range RV2 may be calculated according to the formula "(Q2-Q1)÷(Qf-Qi)". The capacity ratio for the third voltage range RV3 may be calculated according to the formula "(Qf-Q2)÷(Qf-Qi)".

The control unit 120 may be configured to compare the calculated capacity ratio for each of a plurality of voltage ranges with a preset reference capacity ratio.

Specifically, the reference capacity ratio may be preset for each of a plurality of voltage ranges. For example, the reference capacity ratio may be a capacity ratio set for a reference battery. In other words, the capacity for each voltage range on the basis of the total capacity of the battery in the beginning of life (BOL) state may be set to the reference capacity ratio for that voltage range. Here, the reference battery may be the battery in the BOL state, a reference battery set as a comparison target, or a virtual battery based on theory.

Then, the capacity ratio may be calculated for each of the plurality of voltage ranges. Thus, the control unit 120 may compare the capacity ratio calculated for each of the plurality of voltage ranges with the reference capacity ratio. For example, the control unit 120 may calculate the capacity ratio difference between the capacity ratio and the reference capacity ratio.

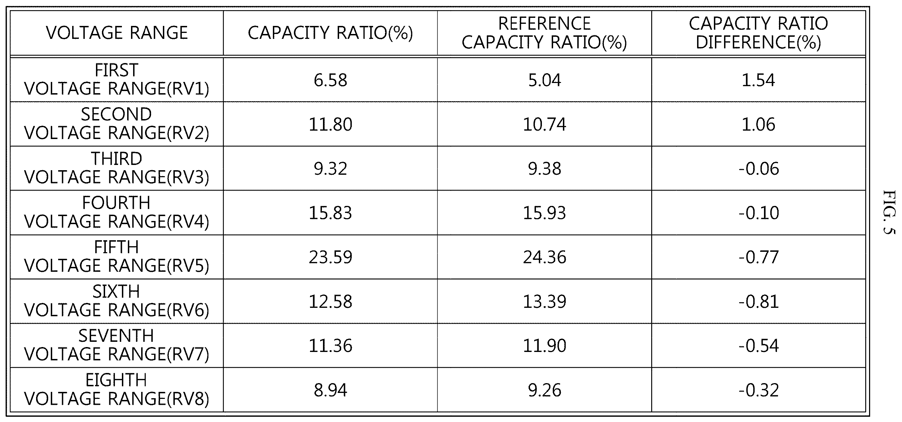

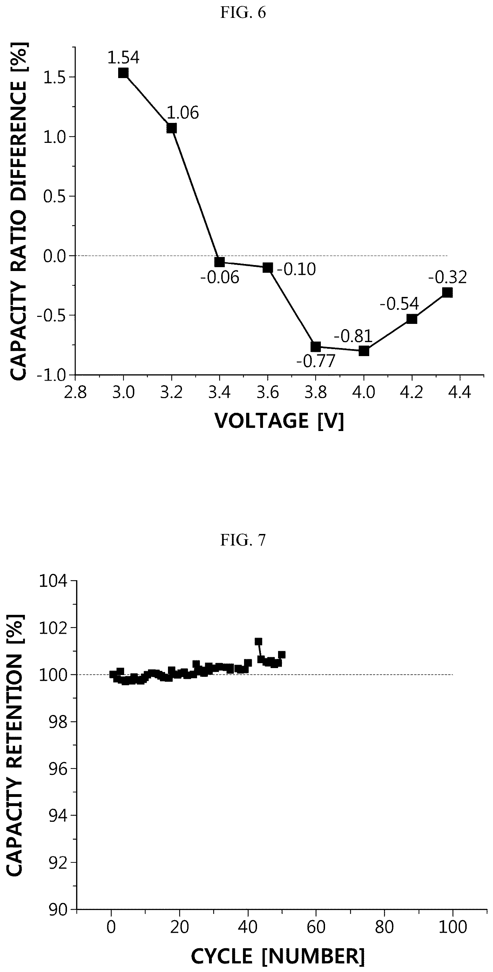

FIG. 4 is a diagram schematically illustrating the capacity ratio for each voltage range and the reference capacity ratio according to one embodiment of the present disclosure. FIG. 5 is a diagram schematically illustrating the capacity ratio for each voltage range and the reference capacity ratio according to one embodiment of the present disclosure. FIG. 6 is a diagram schematically illustrating the capacity ratio difference between the capacity ratio for each voltage range and the reference capacity ratio according to one embodiment of the present disclosure.

In the embodiments of FIGS. 5 to 7, the entire voltage range of the battery is divided into eight voltage ranges. Specifically, the entire voltage range of the battery is divided into the first to eighth voltage ranges RV1 to RV8.

The capacity ratio for the first voltage range RV1 is 6.58%, while the reference capacity ratio is 5.04%. The control unit 120 may calculate the capacity ratio difference of "1.54%" for the first voltage range RV1 using the formula "6.58-5.04".

The capacity ratio for the second voltage range RV2 is 11.80%, while the reference capacity ratio is 10.74%. The control unit 120 may calculate the capacity ratio difference of "1.06%" for the second voltage range RV2 using the equation "11.80-10.74".

The capacity ratio for the third voltage range RV3 is 9.32%, while the reference capacity ratio is 9.38%. The control unit 120 may calculate the capacity ratio difference of "-0.06%" for the third voltage range RV3 using the equation "9.32-9.38".

The capacity ratio for the fourth voltage range RV4 is 15.83%, while the reference capacity ratio is 15.93%. The control unit 120 may calculate the capacity ratio difference of "-0.10%" for the fourth voltage range RV4 using the equation "15.83-15.93".

The capacity ratio for the fifth voltage range RV5 is 23.59%, while the reference capacity ratio is 24.36%. The control unit 120 may calculate the capacity ratio difference of "-0.77%" for the fifth voltage range RV5 using the equation "23.59-24.36".

The capacity ratio for the sixth voltage range RV6 is 12.58%, while the reference capacity ratio is 13.39%. The control unit 120 may calculate the capacity ratio difference of "-0.81%" for the sixth voltage range RV6 using the equation "12.58-13.39".

The capacity ratio for the seventh voltage range RV7 is 11.36%, while the reference capacity ratio is 11.90%. The control unit 120 may calculate the capacity ratio difference of "-0.54%" for the seventh voltage range RV7 using the equation "11.36-11.90".

The capacity ratio for the eighth voltage range RV8 is 8.94%, while the reference capacity ratio is 9.26%. The control unit 120 may calculate the capacity ratio difference of "-0.32%" for the eighth voltage range RV8 using the equation "8.94-9.26".

The control unit 120 may be configured to determine the state of a battery based on the comparison result.

Specifically, the control unit 120 may determine the state of the battery based on the capacity ratio difference between the capacity ratio for each voltage range and the reference capacity ratio. The battery may manifest an additional capacity beyond the designed capacity of the battery due to redox reactions, which may lead to a capacity ratio difference across the voltage ranges. Thus, the control unit 120 may determine whether an additional capacity of the battery has manifested due to the positive electrode degradation based on the capacity ratio difference across the voltage ranges.

In an embodiment, the battery may be configured to contain lithium-excess manganese-based oxides having a crystal structure where a layered LiMO₂ phase (where M is Ni, Co, or Mn) and a rock-salt structured Li₂MnO₃ phase are mixed. Batteries containing lithium-excess manganese-based oxides may achieve a higher capacity through the activation of the rock-salt phase during charging or discharging, which leads to the manifestation of an additional capacity due to oxygen redox reactions. However, there is a problem in that a significant amount of gas is generated during oxygen redox reactions, and the crystal structure of the positive electrode active material changes, resulting in deteriorated lifespan characteristics.

FIG. 7 is a diagram schematically illustrating the capacity retention of the battery according to one embodiment of the present disclosure. Here, the capacity retention refers to the capacity in each cycle compared to the BOL capacity. For example, when the capacity retention is 100%, it means that the capacity in that cycle is equal to the BOL (Beginning of Life) capacity. In another example, if the capacity retention is less than 100%, it means that the capacity in that cycle has decreased compared to the BOL capacity. In a further example, when the capacity retention exceeds 100%, it means that the capacity in that cycle has increased compared to the BOL capacity.

In the embodiment of FIG. 7, the capacity retention of the battery containing a lithium-excess manganese-based oxide may increase as initial cycles progress. This phenomenon is caused by the manifested additional capacity due to redox reactions, as described above.

Thus, the battery management apparatus 100 has an advantage of being able to more specifically determine degradation in the positive electrode of the battery by determining whether an additional capacity of the battery has manifested based on relatively simple comparison between the capacity ratio for each voltage range and the reference capacity ratio.

Meanwhile, the control unit 120 included in the battery management apparatus 100 may selectively include a processor, an application-specific integrated circuit (ASIC), another chipset, logic circuit, register, communication modem, data processing device, and others, as known in the art to execute various control logics performed in the present disclosure. Additionally, when the control logic is implemented in software, the control unit 120 may be implemented as a set of program modules. At this time, the program modules may be stored in a memory and be executed by the control unit 120. The memory may be located inside or outside the control unit 120 and may be connected to the control unit 120 by various well-known components.

In one embodiment, the control unit 120 may be configured to calculate the capacity ratio difference between the capacity ratio for a target voltage range among a plurality of voltage ranges and the reference capacity ratio.

First, the control unit 120 may be configured to determine, as a target voltage range, a voltage range where the capacity ratio is greater than or equal to the reference capacity ratio, among a plurality of voltage ranges.

The voltage range where the capacity ratio is greater than or equal to the reference capacity ratio indicates a voltage range where the capacity of the battery has further increased due to the redox reactions. For example, in the embodiment of FIGS. 5 to 7, the first voltage range RV1 and the second voltage range RV2 correspond to the voltage range where the capacity ratio is greater than or equal to the reference capacity ratio. Specifically, the first voltage range RV1 has a capacity ratio (6.58%) that is 1.54% greater than the reference capacity ratio (5.04%), and the second voltage range RV2 has a capacity ratio (11.80%) that is 1.06% greater than the reference capacity ratio (10.74%).

The control unit 120 may determine the first voltage range RV1 and the second voltage range RV2 as target voltage ranges. Then, the control unit 120 may calculate the capacity ratio difference across the target voltage ranges as 2.60% (1.54%+1.06%).

The control unit 120 may be configured to calculate the manifested capacity ratio due to the positive electrode of the battery according to the calculated capacity ratio difference.

Specifically, the control unit 120 may calculate the manifested capacity ratio due to the positive electrode of the battery from the calculated capacity ratio difference. Here, the manifested capacity ratio refers to the ratio of the manifested additional capacity due to redox reactions compared to the designed capacity of the battery. The manifested capacity ratio may be described as the ratio of the manifested additional capacity (capacity manifested due to the redox reactions) to the designed capacity.

For example, in the embodiment of FIG. 5, assuming that the designed capacity of the battery is 100%, the control unit 120 may calculate the manifested capacity ratio as 2.60%. It can be said that the capacity of the battery has increased by 2.60% compared to the initial capacity due to redox reactions of the battery. Furthermore, the control unit 120 may quantitatively calculate the manifested additional capacity due to the redox reactions based on the designed capacity of the battery 10 and the calculated manifested capacity ratio.

The battery management apparatus 100 may not only determine whether an additional capacity of the battery has manifested but also quantitatively evaluate the manifested additional capacity, providing a significant advantage in more specifically determining the state of the battery.

Preferably, the control unit 120 may be configured to determine voltage ranges starting from the lowest voltage range, among a plurality of voltage ranges, where the capacity ratio is greater than or equal to the reference capacity ratio as target voltage ranges.

Specifically, the capacity manifestation of the battery containing a lithium-excess manganese-based oxide may occur as the crystal structure of the positive electrode active material changes. Then, the redox reactions of the positive electrode active material occur at the initial voltage stage of charging or at the terminal voltage stage of discharging. In summary, even if there are a plurality of voltage ranges where the capacity ratio is greater than or equal to the reference capacity ratio, only the voltage ranges starting from the lowest voltage range may be determined as target voltage ranges.

For example, in the embodiment of FIGS. 5 and 6, the lowest voltage range is the first voltage range RV1, and voltage ranges starting from the lowest voltage range, where the capacity ratio is greater than or equal to the reference capacity ratio, are the first voltage range RV1 and the second voltage range RV2. Thus, the control unit 120 may determine the first voltage range RV1 and the second voltage range RV2 as target voltage ranges.

It is assumed that the capacity ratio for the third voltage range RV3 is greater than or equal to the reference capacity ratio. The control unit 120 may determine the first to third voltage ranges RV1 to RV3 as target voltage ranges since the first to third voltage ranges RV1 to RV3 are successive.

It is assumed that the capacity ratio is greater than or equal to the reference capacity ratio for at least one of the fourth to eighth voltage ranges RV4 to RV8. In this case, there could be three or more voltage ranges where the capacity ratio is greater than or equal to the reference capacity ratio. However, since only the first voltage range RV1 and the second voltage range RV2 are successive, starting from the lowest voltage range, the control unit 120 may determine the first voltage range RV1 and the second voltage range RV2 as target voltage ranges.

The battery management apparatus 100 may specifically determine target voltage ranges among a plurality of voltage ranges, allowing for more precise determination of additional capacity manifestation due to redox reactions of the positive electrode active material, as well as more specific evaluation of the manifested additional capacity.

The control unit 120 may be configured to compare the manifested capacity ratio with a preset threshold and to change a usage condition specified for the battery based on the comparison result.

As described above, the capacity manifestation of the battery containing a lithium-excess manganese-based oxide may occur as the crystal structure of the positive electrode active material changes. For example, while an additional capacity may be manifested in the battery due to changes in the crystal structure of the positive electrode active material, degradation of the positive electrode may also occur. The manifested capacity ratio may be regarded as a factor proportional to the degree of positive electrode degradation.

Thus, the control unit 120 may indirectly determine the degradation degree of the battery (specifically, the degree of positive electrode degradation) by comparing the manifested capacity ratio with a preset threshold. Then, the control unit 120 may change a present usage condition specified for the battery.

For example, when the manifested capacity ratio exceeds a threshold, the control unit 120 may reduce at least one of the upper limit for the preset charge/discharge C-rate, the upper limit for the available SOC, the maximum allowable voltage, or the maximum allowable temperature for the battery.

The battery management apparatus 100 may appropriately change the usage condition for the battery by indirectly determining the degradation degree of the battery through the manifested capacity ratio. Thus, since the accelerated degradation of the battery may be prevented or suppressed, the expected lifespan of the battery may be extended.

The battery management apparatus 100 according to the present disclosure can be applied to the BMS. In other words, the BMS according to the present disclosure may include the above-described battery management apparatus 100. In this configuration, at least some of the components of the battery management apparatus 100 may be implemented by supplementing or adding functions of components included in a conventional BMS. For example, the storage unit 110 and the control unit 120 of the battery management apparatus 100 may be implemented as components of a BMS.

Additionally, the battery management apparatus 100 according to the present disclosure may be provided in a battery pack. That is, the battery pack according to the present disclosure may include the above-described battery management apparatus 100 and at least one battery cell. Also, the battery pack may further include electrical components (relays, fuses, etc.) and a case.

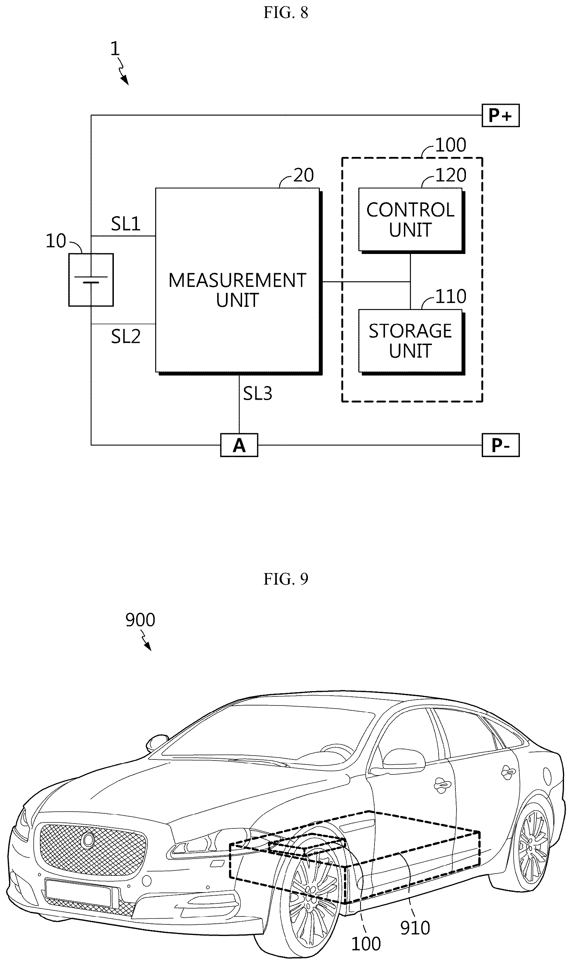

FIG. 8 is a diagram schematically illustrating an example configuration of a battery pack according to another embodiment of the present disclosure.

The positive terminal of the battery 10 may be connected to a positive terminal P+ of the battery pack 1, and the negative terminal of the battery 10 may be connected to a negative terminal P- of the battery pack 1.

The measurement unit 20 may be connected to a first sensing line SL1, a second sensing line SL2, and a third sensing line SL3. Specifically, the measurement unit 20 may be connected to the positive terminal of the battery 10 through the first sensing line SL1 and to the negative terminal of the battery 10 through the second sensing line SL2. The measurement unit 20 may measure the voltage of the battery 10 based on the voltage measured in each of the first sensing line SL1 and the second sensing line SL2.

In addition, the measurement unit 20 may also be connected to a current measurement unit A through the third sensing line SL3. For example, the current measurement unit A may be an ammeter or a shunt resistor that may measure the charging current and discharging current of the battery 10. The measurement unit 20 may measure the charging current or discharging current of the battery 10 through the third sensing line SL3.

The voltage and current of the battery 10 measured by the measurement unit 20 may be stored in the storage unit 110. The storage unit 110 of the battery management apparatus 100 may store battery information including the voltage and current of the battery measured by the measurement unit 20.

An external device may be connected to the positive terminal P+ and negative terminal P- of the battery pack 1. For example, the external device may be a charger for the battery 10, or a load powered by the battery 10.

FIG. 9 is a diagram schematically illustrating a vehicle 900 according to another embodiment of the present disclosure.

Referring to FIG. 9, the battery pack according to the embodiment of the present disclosure may be included in the vehicle 900 such as an electric vehicle (EV) or a hybrid vehicle (HV). Then, the battery pack 910 may drive the vehicle 900 by supplying power to a motor through an inverter equipped in the vehicle 900. Here, the battery pack 910 may include the battery management apparatus 100. For example, the vehicle 900 may include the battery management apparatus 100. In this case, the battery management apparatus 100 may be an onboard diagnostic device included in the vehicle 900.

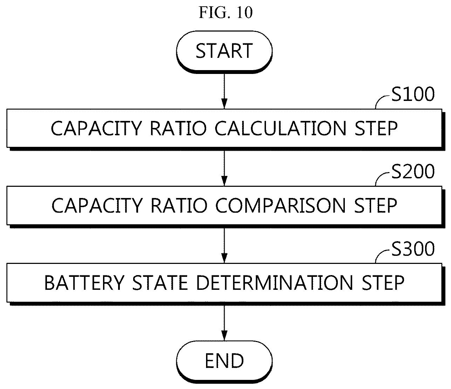

FIG. 10 is a diagram schematically illustrating a battery management method, according to another embodiment of the present disclosure.

Referring to FIG. 10, the battery management method may include a capacity ratio calculation step S100, a capacity ratio comparison step S200, and a battery state determination step S300.

Preferably, each step of the battery management method may be performed by the battery management apparatus 100. Hereinafter, for the convenience of description, descriptions that overlap with those already described will be omitted or briefly described.

The capacity ratio calculation step S100 involves calculating the capacity ratio of the battery for each voltage range based on battery information including the voltage and current of the battery, and may be executed by the control unit 120.

For example, the control unit 120 may be configured to calculate the total capacity for the entire voltage range of the battery. Then, the control unit 120 may calculate the ratio of the calculated total capacity that corresponds to each voltage range, thereby calculating the capacity ratio for that voltage range.

For example, in the embodiment of FIG. 5, the capacity ratio for the first voltage range RV1 is 6.58%, the capacity ratio for the second voltage range RV2 is 11.80%, and the capacity ratio for the third voltage range RV3 is 9.32%. Then, the capacity ratio for the fourth voltage range RV4 is 15.83%, the capacity ratio for the fifth voltage range RV5 is 23.59%, and the capacity ratio for the sixth voltage range RV6 is 12.58%. Finally, the capacity ratio for the seventh voltage range RV7 is 11.36%, and the capacity ratio for the eighth voltage range RV8 is 8.94%.

The capacity ratio comparison step S200 involves comparing the calculated capacity ratio for each of a plurality of voltage ranges with a preset reference capacity ratio, and may be executed by the control unit 120.

For example, the control unit 120 may calculate the capacity ratio difference between the capacity ratio for each voltage range and the reference capacity ratio.

In the embodiment of FIG. 5, the capacity ratio difference for the first voltage range RV1 is "1.54%", the capacity ratio difference for the second voltage range RV2 is "1.06%", and the capacity ratio difference for the third voltage range (RV3) is "-0.06%". Then, the capacity ratio difference for the fourth voltage range RV4 is "-0.10%", the capacity ratio difference for the fifth voltage range RV5 is "-0.77%", and the capacity ratio difference for the sixth voltage range RV6 is "-0.81%". The capacity ratio difference for the seventh voltage range RV7 is "-0.54%", and the capacity ratio difference for the eighth voltage range RV8 is "-0.32%".

The battery state determination step S300 involves determining the state of the battery based on the comparison result from the capacity ratio comparison step S200, and may be executed by the control unit 120.

For example, the control unit 120 may more specifically determine the state of the battery by determining whether an additional capacity of the battery has manifested and by evaluating the amount of the manifested additional capacity.

The embodiments of the present disclosure described above are not only implementable through devices and methods, but may also be implemented via programs that realize functions corresponding to the configuration of the embodiments of the present disclosure or through a recording medium on which such programs are recorded. Such implementations may be easily realized by those skilled in technical field to which the present disclosure belongs based on the description of the embodiments described above.

Although the present disclosure has been described above in detail with reference to limited embodiments and drawings, the present disclosure is not limited thereto, and various modifications and variations may be made by those skilled in the art within the technical idea of the present disclosure and the scope of equivalents of the patent claims described below.

In addition, the present disclosure described above may be substituted, modified, and changed in various ways without departing from the technical spirit of the present disclosure by those skilled in the art, and therefore, the present disclosure is not limited by the above-described embodiments and the accompanying drawings. All or part of each embodiment may be selectively combined and configured to allow various modifications to be made.

### [Reference Signs]

1: battery pack
10: battery
20: measurement unit
100: battery management apparatus
110: storage unit
120: control unit
900: vehicle
910: battery pack

## Claims

1. A battery management apparatus comprising:
a storage configured to store battery information including a voltage and current of a battery; and
a controller configured to calculate a capacity ratio of the battery based on the battery information, compare the calculated capacity ratio for each of a plurality of voltage ranges with a preset reference capacity ratio, and determine a state of the battery based on a comparison result.

2. The battery management apparatus according to claim 1, wherein the controller is configured to calculate a capacity ratio difference between the capacity ratio for a target voltage range among the plurality of voltage ranges and the reference capacity ratio, and calculate a manifested capacity ratio due to a positive electrode of the battery based on the calculated capacity ratio difference.

3. The battery management apparatus according to claim 2, wherein the controller is configured to determine a voltage range where the capacity ratio is greater than or equal to the reference capacity ratio, among the plurality of voltage ranges, as the target voltage range.

4. The battery management apparatus according to claim 3, wherein the controller is configured to determine, among the plurality of voltage ranges, a voltage range starting from a lowest voltage range, where the capacity ratio is greater than or equal to the reference capacity ratio as the target voltage range.

5. The battery management apparatus according to claim 2, wherein the controller is configured to compare the manifested capacity ratio with a preset threshold, and, based on a comparison result, change a usage condition set for the battery.

6. The battery management apparatus according to claim 1, wherein the controller is configured to calculate a total capacity for an entire voltage range of the battery, and calculate a ratio of the calculated total capacity that corresponds to a capacity for each voltage range, so as to calculate the capacity ratio for that voltage range.

7. The battery management apparatus according to claim 1, wherein the battery is configured to contain a lithium-excess manganese-based oxide having a crystal structure where a layered LiMO₂ phase (where M is Ni, Co, or Mn) and a rock-salt structured Li₂MnO₃ phase are mixed.

8. A battery pack comprising the battery management apparatus according to any one of claims 1 to 7.

9. A vehicle comprising the battery management apparatus according to any one of claims 1 to 7.

10. A battery management method comprising:
calculating a capacity ratio of a battery based on battery information including a voltage and current of the battery;
comparing the calculated capacity ratio for each of a plurality of voltage ranges with a preset reference capacity ratio; and
determining a state of the battery based on a comparison result from the comparing.
